# EUROPEAN PATENT SPECIFICATION

(11) **EP 0 703 608 B1**
(45) Date of publication and mention of the grant of the patent: **25.02.1998**
(21) Application number: 94830452.2
(22) Date of filing: 23.09.1994
(51) Int. Cl.: H01L 21/76, H01L 21/265

(54) **Method for forming buried oxide layers within silicon wafers**
Verfahren zur Herstellung begrabener Oxidschichten in einem Silizium-Wafer
Procédé pour former des régions d'oxyde enterrées dans des corps en silicium

(43) Date of publication of application: 27.03.1996
(73) Proprietor: CONSORZIO PER LA RICERCA SULLA MICROELETTRONICA NEL MEZZOGIORNO, 95121 Catania (IT)
(72) Inventor: Campisano, Salvatore Ugo, I-95100 Catania (IT); Raineri, Vito, I-95030 Mascalucia (Prov. of Catania) (IT)
(74) Representative: Modiano, Guido, Dr.-Ing.

(56) References cited:
- EP-A- 0 164 281
- GB-A- 2 211 991
- US-A- 5 372 952
- INTERNATIONAL ELECTRON DEVICES MEETING 1986 DEC. 7-10 1986, 1986, NEW YORK pages 431 - 434 E.J. ZORINSKY ER AL. 'THE "ISLANDS" METHOD- A MANUFACTURABLE POROUS SILICON SOI TECHNOLOGY'
- PATENT ABSTRACTS OF JAPAN vol. 11, no. 4 (E-468) 7 January 1987 & JP-A-61 180 447 (MATSUSHITA)

## Description

The present invention relates to a method for forming buried oxide layers within silicon wafers.

It is known that the availability of thin layers of high-quality single-crystal silicon on insulating material (SOI, Silicon on Insulator) is a fundamental prerequisite for manufacturing various devices, including CMOS, MOSFET, three-dimensional ICs and, more generally, radiation-resistant devices to be used in space or in hostile environments.

There are various established methods for producing SOI materials. Among them, the methods that are significant for the production of semiconductor devices are known as "Silicon on Sapphire" (SOS) and "Separation by Implanted Oxide" (SIMOX).

The SOS method consists in depositing (generally by Chemical Vapor Deposition (CVD)) epitaxial silicon on single-crystal substrates of aluminum trioxide, Al₂O₃. The quality of grown silicon is acceptable, although mainly geminate defects occur at the silicon-crystal interface. A limit to the spread of this technology is the high cost of substrates of single-crystal aluminum trioxide with a diameter that is compatible with current values of single-crystal silicon wafers (5 or 6 inches).

The SIMOX method instead consists in implanting oxygen ions in high doses within single-crystal silicon substrates. Ion implanting must be performed at high temperature to prevent the surface layers from becoming amorphous, and must be followed by a process at very high temperature to remove the residual damage and to form a compact oxide layer. The high dose of oxygen ions to be implanted and the high temperatures required to eliminate the defects lead to high costs and barely acceptable qualities, due to the defects that are present in the silicon layer and to the deformations applied to the entire wafer.

Alternate methods are based on growing epitaxial silicon on windows opened in a layer of thermal oxide grown on silicon substrates. Silicon regrowth proceeds first vertically, up to the level of the grown oxide layer, and then both vertically and horizontally. However, the growth rates are slow and/or produce poor-quality material.

From GB-A-2211991 it is known a process for producing a buried dielectric layer within a body of semiconductor material comprising the steps of implanting ions of hydrogen or an inert gas into the body so as to form a layer of bubbles and/or voids filled with the implanted gas within the body of the semiconductor material, implanting ions of oxygen into the semiconductor material at 800-900° K to facilitate the migration of the oxygen through the crystal lattice to the array of bubbles and/or voids to form voids by the out-diffusion of the implanted ions out of the bubbles. Also a layer of oxide or nitride bridging the gaps between said bubbles and/or voids is formed. Finally, the semiconductor body is annealed in an inert gas such as dry nitrogen.

Patent Abstracts of Japan Vol. 11, No. 4, (E-468), 07-01-1987 (JP-A-61180447) discloses a process for the formation of a silicon island of excellent crystallinity by an etching step which is accomplished after making amorphous an ion-implanted region in a silicon substrate. An amorphous buried region is formed by implantation of hydrogen. Grooves are formed in a superficial epitaxial layer into the amorphous buried region. A buried cavity is formed by etching away the buried region. A buried oxide layer is formed by oxidation in the cavity.

IEDM 1986, p. 431-434 discloses the development and characterization of an isolation process for isolating epitaxial quality silicon films using an anodizable structure of N/N+/N- silicon together with computer-controlled processing for implementing porous silicon technology into a manufacturing environment. Trenches are formed through an N-type epitaxial layer into an underlaying N+-type epitaxial layer. A buried oxide layer is formed by anodization of said anodizable layer.

A principal aim of the present invention is therefore to provide a method for forming buried oxide layers within silicon wafers that is simpler than known methods.

Within the scope of this aim, an object of the present invention is to provide a method for forming buried oxide layers within silicon wafers that is capable of producing high-quality material.

Another object of the present invention is to provide a method for forming buried oxide layers within silicon wafers that has low costs with respect to known methods.

This aim, these objects, and others which will become apparent hereinafter are achieved by a method for forming buried oxide layers within silicon wafers as defined in the appended claim 1.

An important aspect of the present invention is that the above mentioned steps can also be performed in a different sequence.

The characteristics and advantages of the invention will become apparent from the description of a preferred but not exclusive embodiment, illustrated only by way of non-limitative example in the accompanying drawings, wherein:
figure 1 is a transverse sectional view of a silicon wafer containing gas bubbles;
figure 2 is a view of the same silicon wafer, which comprises trenches for the passage of oxygen;
figure 3 is a view of the same silicon wafer during the oxidation step;
figure 4 is a view of the same silicon wafer, which comprises the insulating layer.

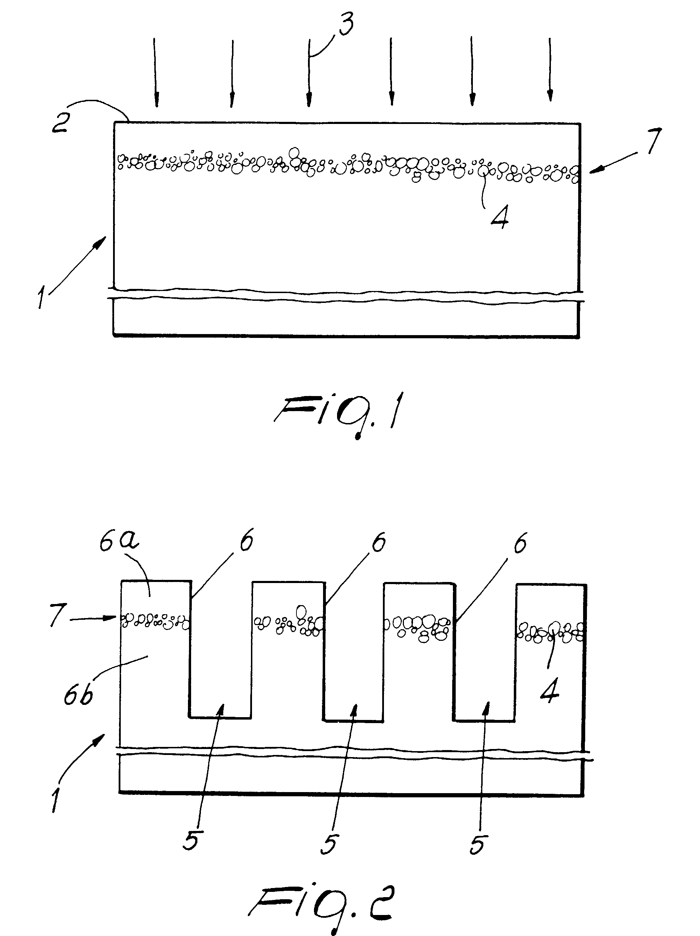

With reference to figure 1, a silicon wafer 1 is subjected to ion implanting on its entire surface 2 with low-mass inert ions 3, advantageously helium. Implanting occurs with relatively high helium doses which vary according to the implanting energy. For example, for an implanting energy of 20 KeV the dose is on the order of approximately 5 x 10¹⁶ atoms/sq cm, whereas for an energy of 300 KeV the dose is equal to approximately 1 x 10¹⁶ atoms/sq cm.

A high density of small helium bubbles 4 forms at the average penetration depth of the ions 3. Penetration depth varies according to the implanting energy: for a value of 20 KeV of the implanting energy, penetration depth is equal to 0,3 µm, whereas for an energy of 300 KeV penetration depth is equal to 1 µm.

The silicon wafer 1 is then subjected to heat treatments at temperatures above 700°C. These heat treatments are capable of diffusing the helium present in the bubbles 4 up to the surface 2 of the silicon wafer 1, leaving a buried layer 7 of empty cavities in the place of the bubbles 4.

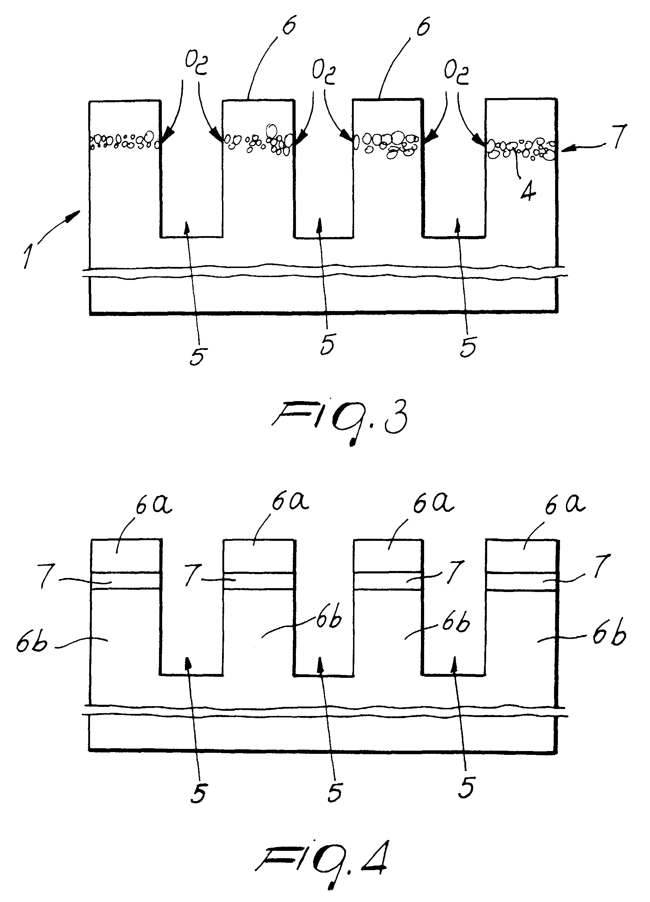

Then, with reference to figure 2, recesses or trenches 5 are formed in the silicon wafer so that they are deeper than the depth at which the cavities 4 are located.

This leaves protruding portions 6 which are divided by the cavities 4 into an upper section 6a and a lower section 6b.

After forming the trenches 5, the silicon wafer 1 is placed in an oxidation furnace (not shown). A fast thermal oxidation system has been chosen in the present embodiment of the present invention, but the oxidation system might be different.

With this oxidation system the silicon wafer 1 was subjected to the flux in an oxygen-rich environment and the temperature was raised to 1000°C for 30 minutes.

The buried layer, which contains a high density of cavities 4, is uniformly oxidized through an oxide thickness that depends on the oxidation time and temperature, as shown in figure 3.

Oxidation of the buried silicon layer 7 is allowed by the transport of oxygen O₂ through the trenches 5 and in the porous structure of the cavity 4 formed by ion implanting.

This forms a uniform buried layer 7 that divides the protruding portions 6 into an upper silicon layer 6a and into a lower layer 6b, as shown in figure 4. The upper layer 6a, insulated by the oxidized buried layer 7, is of high quality, since the slight damage thereof produced by the helium ion implanting is removed during the thermal process that produces oxidation. In particular, the damage occurs in the form of point-like defects which are eliminated by the thermal treatment.

Further thermal processes after the oxidation process are possible and can be used to improve the quality of the silicon itself. The wafer 1 thus obtained can then be introduced in any production cycle for forming semiconductor devices.

The method according to the present invention fully achieves the intended aim and objects. The method according to the present invention is simple, inexpensive, and allows to obtain high-quality material. The simplicity of the method arises from the fact that only a small number of processes is required: the formation of the trenches 5, the implanting of light ions 3 to form cavities 4, and oxidation. These steps can also be performed in a sequence other than the one described herein.

The lower cost arises from the fact that no particular substrates are used and that the above described steps are well-known and normally used in the production of semiconductor devices. Intense beams of helium and other light ions can be easily extracted from conventional ion implanting machines.

The high quality of the material obtained arises from the fact that the light ions produce defects that can be easily eliminated close to the surface of the specimen.

The invention thus conceived is susceptible of numerous modifications and variations, all of which are within the scope of the inventive concept.

Thus, for example, various light elements can be used instead of helium. The formation of bubbles by implanting hydrogen and noble gases, including even heavier ions (included in any case within the category of light atoms) such as neon, has also been shown.

It is furthermore possible to form the trench structure 5 first and then implant the ions.

The structure shown in figure 2 can furthermore be formed in different ways; for example, the silicon columns or protruding portions 6 can be grown on the surface of the wafer 1.

In this way the various production steps can be performed in different orders. The cavities 4 can also be formed during the oxidation process itself instead of as a separate step.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A method for forming buried oxide layers within silicon protrusions formed in or on silicon wafers, comprising the following steps:
forming protrusions (6) alternated by recesses (5) by forming trenches (5) in a silicon wafer (1) or by growing protruding portions of silicon (6) on a silicon wafer (1);
implanting light ions (3) in said silicon protrusions (6) at a depth that is smaller than the depth of said recesses, so as to form bubbles (4) of said light ions (3) in said silicon protrusions (6);
evaporating said light ions (3) through said silicon protrusions (6) so as to leave cavities in the place of said bubbles (4), said evaporation being provided by a thermal treatment of said silicon protrusions (6) at temperatures above 700°C;
oxidizing in an oxidation furnace the silicon surrounding said cavities through said recesses (5) so as to form a buried layer (7) of silicon oxide.

2. A method for forming buried oxide layers within silicon protrusions formed in or on silicon wafers, comprising the following steps:
implanting light ions (3) on the entire surface of a silicon wafer (1) so as to form, at the average penetration depth of said light ions (3), a plurality of bubbles (4) of said light ions (3);
subjecting said silicon wafer (1) to a thermal treatment at temperatures above 700°C so as to evaporate said light ions (3) so as to leave cavities in the place of said bubbles (4);
forming protrusions alternated by recesses (5) by forming trenches (5) in a silicon wafer (1) said recesses being at a depth which is greater than the depth at which said cavities are located;
oxidizing in an oxidation furnace the silicon surrounding said cavities through said recesses (5) so as to form a buried layer (7) of silicon oxide.

3. A method according to claim 1, characterized in that said cavities are produced at the same time when said oxidation is performed.

4. A method according to claim 1 or 2, characterized in that said light ions (3) are ions of a noble gas.

5. A method according to claim 4, characterized in that said noble gas is helium.

6. A method according to claim 4, characterized in that said noble gas is neon.

7. A method according to claim 1 or 2, characterized in that said light ions (3) are hydrogen ions.

8. A method according to one or more of the preceding claims, characterized in that said thermal treatment eliminates the defects produced by said light ion implanting.

## Patentansprüche

1. Verfahren zum Herstellen vergrabener Oxidschichten innerhalb in oder auf Siliziumwafern gebildeten Siliziumerhebungen, mit den folgenden Schritten:
mit Ausnehmungen (5) alternierende Erhebungen (6) werden gebildet, indem Einschnitte (5) in einem Siliziumwafer (1) gebildet werden, oder indem sich erhebende Abschnitte aus Silizium (6) auf einem Siliziumwafer (1) gewachsen werden;
Lichtionen (3) werden in den Siliziumerhebungen (6) in einer Tiefe implantiert, die kleiner ist als die Tiefe der Ausnehmungen, um so Blasen (4) der Lichtionen 13) in den Siliziumerhebungen (6) zu bilden;
die Lichtionen (3) werden durch die Siliziumerhebungen (6) verdampft, um so Hohlräume anstelle der Blasen (4) zu hinterlassen, wobei die Verdampfung durch eine thermische Behandlung der Siliziumerhebungen (6) bei Temperaturen oberhalb von 700° C zur Verfügung gestellt wird;
das die Hohlräume umgebende Silizium wird durch die Ausnehmungen (5) in einem Oxidationsofen oxidiert, um so eine eingegrabene Schicht (7) aus Siliziumoxid zu bilden.

2. Verfahren zum Herstellen vergrabener Oxidschichten innerhalb in oder auf Siliziumwafern gebildeten Siliziumerhebungen, mit den folgenden Schritten:
auf der gesamten Oberfläche eines Siliziumwafers (1) werden Lichtionen (3) implantiert, um so in der Durchschnittseindringtiefe der Lichtionen (3) eine Vielzahl von Blasen (4) aus den Lichtionen (3) zu bilden;
der Siliziumwafer (1) wird einer thermischen Behandlung bei Temperaturen oberhalb von 700° C ausgesetzt, um so die Lichtionen (3) zu verdampfen, um so Hohlräume anstelle der Blasen (4) zu hinterlassen;
mit Ausnehmungen (5) alternierende Erhebungen werden gebildet, indem Einschnitte (5) in einem Siliziumwafer (1) gebildet werden, wobei sich die Ausnehmungen in einer Tiefe befinden, welche größer ist als die Tiefe, in welcher sich die Hohlräume befinden;
das die Hohlräume umgebende Silizium wird durch die Ausnehmungen (5) in einem Oxidationsofen oxidiert, um so eine eingegrabene Schicht (7) aus Siliziumoxid zu bilden.

3. Verfahren nach Anspruch 1,
dadurch gekennzeichnet, daß die Hohlräume zu der gleichen Zeit erzeugt werden, in der die Oxidation ausgeführt wird.

4. Verfahren nach Anspruch 1 oder 2,
dadurch gekennzeichnet, daß die Lichtionen (3) lonen eines Edelgases sind.

5. Verfahren nach Anspruch 4,
dadurch gekennzeichnet, daß das Edelgas Helium ist.

6. Verfahren nach Anspruch 4,
dadurch gekennzeichnet, daß das Edelgas Neon ist.

7. Verfahren nach Anspruch 1 oder 2,
dadurch gekennzeichnet, daß die Lichtionen (3) Wasserstoffionen sind.

8. Verfahren nach einem oder mehreren der vorstehenden Ansprüche, dadurch gekennzeichnet, daß die thermische Behandlung die durch die Implantation der Lichtionen erzeugten Störstellen eliminiert.

## Revendications

1. Procédé de formation de couches enterrées d'oxyde dans des saillies de silicium formées dans ou sur des tranches de silicium, comprenant les étapes suivantes :
former des saillies (6) alternant avec des évidements (5) en formant des tranchées (5) dans une tranche de silicium (1) ou en faisant croître des parties en saillie de silicium (6) sur une tranche de silicium (1) ;
implanter des ions légers (3) dans les saillies de silicium (6) à une profondeur inférieure à la profondeur des évidements de façon à fromer des bulles (4) desdits ions légers (3) dans les saillies de silicium (6) ;
évaporer les ions légers (3) dans les saillies de silicium (6) de façon à laisser en place des cavités à la place des bulles (4), cette évaporation étant assurée par un traitement thermique des saillies de silicium (6) à des températures supérieures à 700°C ;
oxyder dans un four d'oxydation le silicium entourant les cavités à travers les évidements (5) de façon à former une couche enterrée (7) d'oxyde de silicium.

2. Procédé de formation de couches enterrées d'oxyde dans des saillies de silicium formées dans ou sur des tranches de silicium comprenant les étapes suivantes :
implanter des ions légers (3) sur toute la surface d'une tranche de silicium (I) de façon à former, à la profondeur de pénétration moyenne desdits ions légers (3), une pluralité de bulles (4) desdits légers (3) ;
soumettre la tranche de silicium (1) à un traitement thermique à des températures supérieures à 700°C de façon à évaporer les ions légers (3) pour laisser des cavités à la place desdites bulles (4) ;
former des saillies alternées avec des évidements (5) en formant les manchées (5) dans une tranche de silicium (1), lesdits évidements étant à une profondeur supérieure à la profondeur à laquelle les cavités sont disposées ;
oxyder dans un four d'oxydation le silicium entourant les cavités à travers les évidements (5) de façon à former une couche enterrée (7) d'oxyde de silicium.

3. Procédé selon la revendication 1, caractérisé en ce que les cavités sont formées en même temps que l'oxydation est réalisée.

4. Procédé selon la revendication 1 ou 2, caractérisé en ce que les ions légers (3) des ions d'un gaz noble.

5. Procédé selon la revendication 4, caractérisé en ce que le gaz noble est de l'hélium.

6. Procédé selon la revendication 4, caractérisé en ce que le gaz noble est du néon.

7. Procédé selon la revendication 1 ou 2, caractérisé en ce que les ions légers (3) sont des ions d'hydrogène.

8. Procédé selon une ou plusieurs des revendications précédentes, caractérisé en ce que le traitement thermique élimine les défauts produits par l'implantation d'ions légers.
